Europäisches Patentamt

European Patent Office

Office européen des brevets

(11) Numéro de publication: **0 145 694**
**A2**

## DEMANDE DE BREVET EUROPEEN

(21) Numéro de dépôt: **84870174.4**

(22) Date de dépôt: **12.12.84**

(51) Int. Cl.⁴: **H 01 L 23/56**

(30) Priorité: **14.12.83 LU 85135**

(43) Date de publication de la demande: **19.06.85**
**Bulletin 85/25**

(84) Etats contractants désignés: **AT BE CH DE FR GB IT LI NL SE**

(71) Demandeur: **Bonameau, Jean-Marie, 143, rue Mur du Couvent, B-4653 Bolland (BE)**

(72) Inventeur: **Bonameau, Jean-Marie, 143, rue Mur du Couvent, B-4653 Bolland (BE)**

(54) **Dispositif de protection contre les perturbations et/ou des parasites au voisinage de circuits intégrés.**

(57) La présente invention concerne un dispositif destiné à procurer aux circuits intégrés un blindage efficace contre les perturbations électromagnétiques tout en réalisant un découplage efficace de l'alimentation. Ce dispositif est caractérisé en ce qu'il comprend un élément formant condensateur intégré directement au boîtier de circuit intégré, et comportant deux conducteurs-plans parallèles ayant chacun une surface sensiblement égale à celle de la face principale du circuit intégré, chaque conducteur-plan étant relié électriquement à la broche d'alimentation correspondante de circuit intégré, les deux condensateurs-plans étant séparés par un élément diélectrique. L'invention concerne aussi bien les supports de circuits intégrés que ces derniers.

La présente invention concerne un dispositif de protection contre des perturbations électromagnétiques et/ou des parasites au voisinage de circuits intégrés.

Il est connu que les composants électroniques sont sensibles aux perturbations électromagnétiques et aux parasites en particulier ceux véhiculés par leur alimentation. Par ailleurs, le développement considérable de la technologie conduit à intégrer des fonctions de plus en plus complexes et à engendrer dans les systèmes électroniques des courants de commutation au spectre étendu.

La présente invention a pour but , d'une part, de procurer aux circuits intégrés complexes (tels que microprocesseurs, mémoire morte programmable électriquement ou EPROM, convertisseurs analogiques-numériques, circuits intégrés à grande échelle ou LSI...) un blindage qui est efficace contre les perturbations électromagnétiques et, d'autre part, de réaliser un découplage efficace de l'alimentation au niveau du circuit même.

Pour cela, selon l'invention, le dispositif de protection contre les perturbations électromagnétiques et/ou des parasites au voisinage de circuits intégrés constitués d'un boîtier qui a plusieurs broches monté sur un support de connexion électrique à plusieurs broches, est caractérisé en ce qu'il comprend un élément formant condensateur intégré directement au boîtier du circuit intégré et comportant deux conducteurs-plans parallèles ayant chacun une surface sensiblement égale à celle de la face principale du circuit intégré, chaque conducteur-plan étant relié électriquement à la broche d'ali-

0145694

mentation correspondante du circuit intégré, les deux conducteurs-plans étant séparés par un élément diélectrique.

Selon une autre caractéristique de l'invention, l'élément formant condensateur est intégré au support du circuit intégré et comporte deux conducteurs-plans parallèles ayant chacun une surface sensiblement égale à celle de la face principale du support du circuit intégré, chaque conducteur-plan étant relié électriquement à la broche d'alimentation correspondante du support du circuit intégré, les deux conducteurs-plans étant séparés par un élément diélectrique.

Selon encore une autre caractéristique de l'invention, l'élément diélectrique précité est notamment un élément céramique.

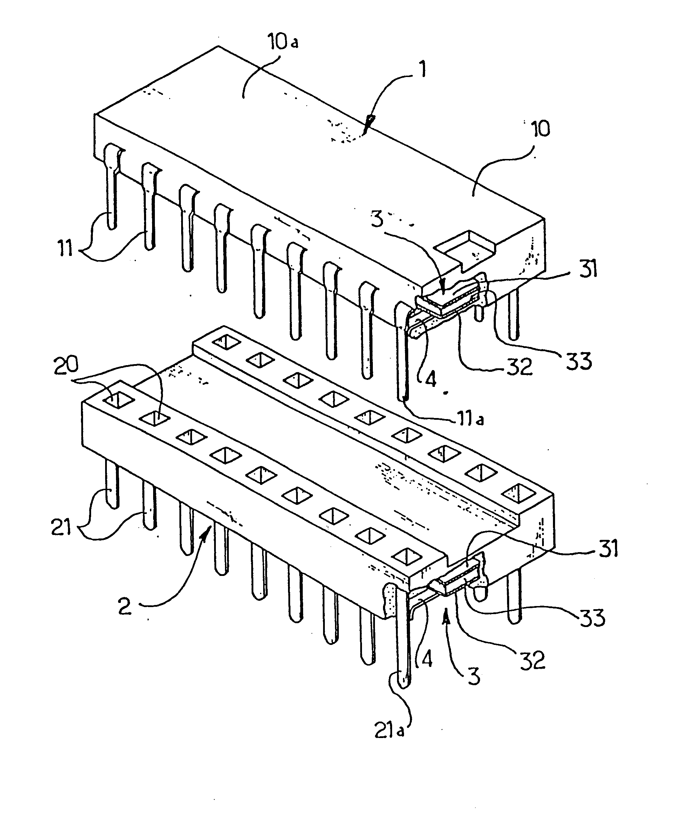

L'invention sera mieux comprise, et d'autres buts caractéristiques, détails et avantages de celle-ci apparaitront plus clairement au cours de la description explicative qui va suivre faite en référence à la figure unique schématique annexée donnée à titre d'exemple illustrant un mode de réalisation de l'invention, et laquelle représente une vue en perspective d'un circuit intégré avec son support associé, munis chacun d'un dispositif de protection selon l'invention.

En se reportant à la figure, il est représenté, repéré par la référence 1, un circuit intégré constitué d'un boîtier 10 auquel sont fixées plusieurs broches 11 reliées à divers composants électroniques intégrés au boîtier 10 et accomplissant certaines fonctions lorsque des signaux électriques adéquats sont appliqués aux broches 11. Le circuit intégré représenté est du type DIL (Dual In Line) à 18 broches mais il va de soi que d'autres circuits intégrés, de tailles différentes et avec un nombre de broches différent, peuvent être munis du dispositif de protection de l'invention qui sera décrit ultérieurement.

La référence 2 désigne un support ou soquet du circuit intégré 1 et réalisé en une matière isolante telle que par exemple du plastique. Le support 2 comporte de petites cavités 20 disposées à intervalles réguliers longitudinalement au support 2 et de part et d'autre de l'axe longitudinale de ce support. Ces cavités, d'un nombre identique à celui des broches 11 du circuit intégré 1, sont destinées à recevoir les broches 11 afin de permettre le montage du circuit intégré 1 sur le support 2. Le support 2 comporte également des broches 21 fixées à celui-ci et associées respectivement aux cavités 20.

De la description qui précède, on comprend que le support 2 peut être fixé par exemple sur un circuit imprimé afin de permettre l'établissement de connexions, par l'intermédiaire des broches 21, entre diverses composants ou circuits électroniques montés sur le circuit imprimé et les éléments ou circuits électroniques du circuit intégré 1 lorsque celui-ci est inséré dans le support 2.

Il va être maintenant décrit le dispositif, selon l'invention, de protection contre les perturbations électromagnétiques et/ou des parasites au voisinage du circuit intégré 1.

Ce dispositif, référencé d'une façon générale en 3 est représenté comme étant associé au circuit intégré 1 et au support 2. En réalité, le dispositif de protection 3 est associé soit au circuit intégré 1, soit au support 2.

Le dispositif de protection 3, lorsqu' associé au circuit intégré 1, est constitué d'un élément formant condensateur intégré au boîtier 10 comme il ressort de la vue éclatée. Cet élément formant condensateur comporte deux conducteurs parallèles 31 et 32 formant les armatures planes ayant chacune une surface sensiblement égale à celle de la face principale 10a du circuit intégré 1. Chaque conducteur-plan est raccordé électriquement à la broche d'alimentation correspondante du circuit intégré. Dans le cas présent le conducteur-plan 32 est relié à la broche d'alimentation 11a par l'intermédiaire d'un conducteur 4, cette broche d'alimentation correspondant par exemple à la polarité positive d'alimentation. Il va de soi que l'autre conducteur-plan 31 est relié à l'autre broche d'alimentation (non représentée) du circuit intégré et qui correspond alors à la polarité négative de l'alimentation.

Comme il ressort également de la figure, les deux conducteurs-plans 31 et 32 sont séparés par un élément diélectrique 33 pris ainsi en sandwich entre les conducteurs-plans 31 et 32 et apte à procurer une capacité répartie suffisante. L'élément diélectrique 33 peut notamment être constitué par un élément céramique.

Les caractéristiques du dispositif de protection 3 associé au support 2 sont identiques à celles du dispositif 3 associé circuit intégré 1. Ainsi ce dispositif de protection comprend les deux conducteurs-plans 31 et 32 ayant une surface sensiblement égale à celle de la face principale du support 2 du circuit intégré 1 avec l'élément diélectrique 33 disposé entre les deux conducteurs-plans. Le conducteur-plan 32 est relié à la broche d'alimentation 21a, par exemple de polarité positive, par l'intermédiaire du conducteur 4 tandis que le conducteur-plan 31 est relié à l'autre broche d'alimentation (non représentée), par exemple de polarité négative.

On comprend que le dispositif de protection selon l'invention, qu'il soit intégré au boîtier 10 du circuit intégré 1 ou au support 2 de ce circuit intégré, permet de procurer au circuit intégré 1 un blindage efficace contre les perturbations électromagnétiques, ce blindage étant effectué par une surface équipotentielle 31 ou 32 recouvrant les dimensions de la face principale du circuit intégré.

D'autre part, le dispositif de protection 3 permet de réaliser un découplage efficace de l'alimentation au niveau du cicuit même par minimisation de la self inductance série de l'élément condensateur vu du circuit intégré lui-même.

L'ensemble formé par les deux conducteurs-plans et l'élément diélectrique pourrait, par exemple, être surmoulé avec le circuit intégré ou avec les broches du soquet standard, après que le raccordement électrique des deux conducteurs-plans ait eu lieu. Dans le cas de l'intégration au circuit intégré, l'ensemble condensateur peut également favoriser l'échange thermique du circuit intégré avec l'ambiance et permettre ainsi un meilleur comportement du circuit dans une plage de température étendue. Dans ce cas, les broches d'accès pourraient être dimensionnées en conséquence.

Il va de soi que l'épaisseur de l'ensemble formé par les deux conducteurs-plans et l'élément diélectrique est extrèmement faible et que cet ensemble a été volontairement agrandi sur la figure à titre de compréhension.

De plus, comme déjà précisé précedemment, d'autres circuits intégrés, de tailles différentes et ayant un nombre de broches différents (40 par exemple) peuvent comporter le dispositif de protection selon la présente invention. Ainsi, les dispositifs SIL (Single In Line) fréquemment utilisés en technologie hybrides conviennent également.

6                    ·    0145694

R E V E N D I C A T I O N S
================================

1.- Dispositif de protection contre des perturbations électromagnétiques et/ou des parasites au voisinage de circuits intégrés constitués d'un boîtier à plusieurs broches monté sur un support de connexion électrique à plusieurs broches, caractérisé en ce qu'il comprend un élément formant condensateur(3) intégré directement au boîtier(10) du circuit intégré(1) et comportant deux conducteurs-plans parallèles (31, 32) ayant chacun une surface sensiblement égale à celle de la face principale(10a) du circuit intégré, chaque conducteur-plan étant relié électriquement à la broche d'alimentation correspondante du circuit intégré, les deux conducteurs-plans étant séparés par un élément diélectrique(33).

2.- Dispositif de protection contre des perturbations électromagnétiques et/ou des parasites au voisinage de circuits intégrés constitués d'un boîtier à plusieurs broches monté sur un support de connexion électrique à plusieurs broches, caractérisé en ce qu'il comprend un élément formant condensateur(3) intégré au support(2) du circuit intégré (1) et comportant deux conducteurs-plans parallèles (31,32) ayant chacun une surface sensiblement égale à celle de la face principale du support (2) du circuit intégré, chaque conducteur-plan étant relié électriquement à la broche d'alimentation correspondante du support, les deux conducteurs-plans étant séparés par un élément diélectrique (33).

3.- Dispositif selon la revendication 1 ou 2, caractérisé en ce que l'élément diélectrique (33) précité est notamment un élément céramique.